(19) Europäisches Patentamt

European Patent Office

Office européen des brevets

(11) **EP 1 441 437 B1**

(12) **FASCICULE DE BREVET EUROPEEN**

(45) Date de publication et mention
de la délivrance du brevet:
**09.08.2006 Bulletin 2006/32**

(51) Int Cl.:
**H03B 27/00** *(2006.01)*

(21) Numéro de dépôt: **03075206.7**

(22) Date de dépôt: **21.01.2003**

(54) **Générateur de signaux en quadrature de phase et à asservissement de la fréquence de travail**

Betriebsfrequenzgesteuerte Quadratursignalgenerator

Operating frequency controlled quadrature signal generator

(84) Etats contractants désignés:
**CH DE FR GB LI**

(43) Date de publication de la demande:
**28.07.2004 Bulletin 2004/31**

(73) Titulaire: **CSEM Centre Suisse d'Electronique et de**
**Microtechnique S.A. - Recherche et**
**Développement**
**2007 Neuchâtel (CH)**

(72) Inventeur: **Melly, Thierry**
**1015 Lausanne (CH)**

(74) Mandataire: **Ravenel, Thierry Gérard Louis et al**
**I C B,**
**Ingénieurs Conseils en Brevets SA,**
**7, rue des Sors**
**2074 Marin (CH)**

(56) Documents cités:
**EP-A- 0 837 560        EP-A- 1 091 483**
**US-A- 5 644 260**

## Description

La présente invention est relative à un générateur de signaux en quadrature de phase utilisé notamment dans le domaine des transmissions, pour des applications telles que des récepteurs ou émetteurs à réjection de la fréquence image.

Ce générateur de signaux comprend des moyens de déphasage formés d'éléments passifs permettant de délivrer des signaux en quadrature de phase à partir d'un signal d'entrée reçu.

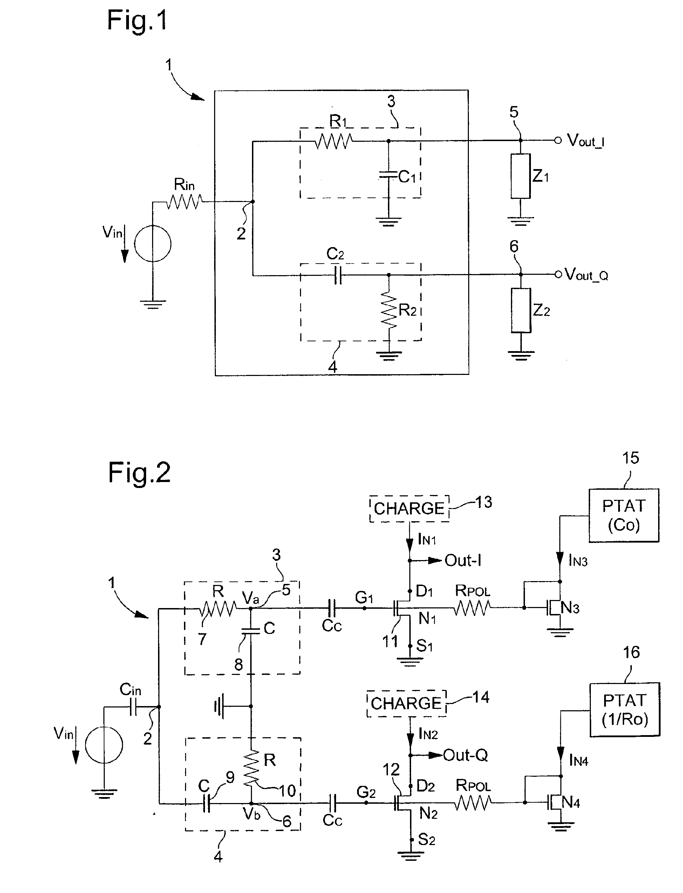

De tels générateurs, également appelés déphaseurs I-Q (pour Inphase et Quadrature), sont connus de l'art antérieur. Le principe général est décrit à la figure 1 représentant un générateur dont le déphaseur 1 utilise un étage de filtre passif du type RC-CR. Un signal d'entrée Vin est reçu à une borne d'entrée 2 du déphaseur. Ce signal Vin est fourni à un premier circuit déphaseur 3 comprenant une résistance R1 connectée entre la borne d'entrée 2 et une première borne de sortie 5 du générateur et un condensateur C1 connecté entre cette borne de sortie 5 et un potentiel de référence, par exemple à la masse. Le signal Vout_I délivré à la borne de sortie 5 de ce premier circuit déphaseur 3 est déphasé par rapport au signal Vin fourni en entrée. Ce signal Vin est fourni en parallèle à un deuxième circuit déphaseur 4 comprenant un condensateur C2 connecté entre la borne d'entrée 2 et une deuxième borne de sortie 6 du déphaseur 1 et une résistance R2 connectée entre cette deuxième sortie et la masse. Le signal Vout_Q délivré à la borne de sortie 6 est également déphasé par rapport au signal Vin fourni en entrée. Les signaux Vout_I et Vout_Q sont déphasés de 90° l'un par rapport à l'autre, c'est pourquoi l'on parle de signaux en quadrature de phase.

En considérant les impédances de sortie Z1 et Z2 associées aux bornes de sortie 5 et 6, on obtient comme fonction de transfert entre les signaux de sortie Vout_I et Vout_Q, l'équation suivante :

$$\frac{Vout\_I}{Vout\_Q}=\frac{1}{j\omega.R2.C2}\cdot\frac{1+j\omega.R2.C2+\frac{R2}{Z2}}{1+j\omega.R1.C1+\frac{R1}{Z1}}$$

Ce type de générateur présente un intérêt accru lorsque les signaux en quadrature de phase Vout_I et Vout_Q ont la même amplitude. Pour cela, il est nécessaire que la fonction de transfert explicitée ci-avant ait un module valant 1.

Ce type de circuit est intégré sur des plaquettes à gravure, appelées communément "wafers" suivant la terminologie anglo-saxonne. L'appariement des éléments passifs, comme les valeurs de résistance ou de capacité, peut être réalisé à un ordre de grandeur acceptable sur un même wafer, de l'ordre du %. Cet ordre de grandeur varie néanmoins suivant la technologie utilisée.

En admettant un appariement parfait des valeurs de résistance (R1 = R2 = R), des valeurs de capacité (C1 = C2 = C) et des valeurs d'impédance (Z1 = Z2), la fonction de transfert peut être simplifiée comme suit :

$$\frac{Vout\_I}{Vout\_Q}=\frac{1}{j\omega.R.C}$$

Les amplitudes des signaux de sortie Vout_I et Vout_Q sont donc égales pour une seule fréquence $f_0$, appelée aussi fréquence de coupure, dont la pulsation correspondante $\omega_0$ vaut $\frac{1}{R.C}\cdot$

Néanmoins ce type de générateur de signaux en quadrature de phase présente quelques inconvénients. En effet, comme il a été mentionné précédemment, l'appariement des éléments passifs d'un circuit ne peut être assuré de manière acceptable que sur un même wafer. Pour de tels circuits, la dispersion entre les éléments passifs d'un wafer à un autre wafer est relativement importante, pouvant être de l'ordre de $\pm30\%$ par exemple pour une technologie CMOS digitale.

Ainsi la fréquence $f_0$, qui dépend directement des valeurs de ces éléments passifs, varie largement d'un wafer à l'autre, ce qui pose de sérieux problèmes pour des applications utilisant une fréquence de travail donnée.

De plus, cette dispersion représente un inconvénient majeur, en particulier dans des applications du type récepteur à réjection de la fréquence image. Dans le cadre de telles applications, il est prévu des moyens de filtrage pour filtrer toute la gamme de fréquences susceptible de contenir la fréquence image pour ne retenir que celle des signaux engendrés à la fréquence de travail.

Certaines solutions ont déjà été proposées dans l'art antérieur pour éviter les inconvénients susmentionnés. Une première solution de l'art antérieur consiste à utiliser un filtre polyphasé passif à plusieurs étages utilisant des fréquences de coupure différentes. Le nombre d'étages et le placement des pôles, définissant les différentes fréquences de coupure, permettent d'évaluer la qualité de la réjection de la fréquence image en fonction du désappariement des composants et de leur valeur absolue. Cette solution présente l'inconvénient de diminuer l'amplitude des signaux à la sortie de chaque étage.

Une autre solution selon l'art antérieur consiste à réaliser un filtre polyphasé actif. La synthèse de ce type de filtre requiert l'utilisation de plusieurs transconducteurs à dynamique élevée. La consommation et la surface de ces filtres sont importantes.

Dans d'autres applications où l'amplitude des signaux n'est pas importante, car non porteuse d'information, on peut s'affranchir de l'erreur d'amplitude en utilisant, pour chacun des signaux en quadrature, un amplificateur à grand gain qui en limite l'amplitude, mais cela au prix d'une consommation importante.

Le document US-A-5 644 260 décrit un générateur de signaux en quadrature de phase qui utilise deux amplificateurs avec des détecteurs de niveau, suivi de deux amplificateurs/limiteurs, afin d'annuler la différence en amplitude entre les deux voies I et Q en quadrature de phase.

On notera que chacune de ces solutions pénalise fortement la consommation du circuit et que la réjection de la fréquence image reste limitée dans tous les cas du fait du désappariement des composants utilisés d'un wafer à l'autre.

L'invention a pour but de pallier les inconvénients susmentionnés de l'art antérieur, notamment de limiter la consommation d'un tel circuit et d'obtenir des signaux en quadrature de phase indépendants des composants passifs du circuit.

Pour cela, l'invention concerne un générateur de signaux en quadrature de phase tel que défini en préambule, caractérisé en ce qu'il comprend en outre, entre les moyens de déphasage et les bornes de sortie, des moyens transconducteurs ayant une transconductance proportionnelle aux éléments passifs, agencés de manière à obtenir une fonction de transfert entre lesdits premier et deuxième signaux en quadrature de phase délivrés en sortie, indépendante desdits éléments passifs.

Selon un aspect de l'invention, les moyens transconducteurs comprennent des premier et deuxième circuit transconducteurs qui ont chacun une transconductance indépendante de la température de manière à obtenir une fonction de transfert entre les signaux en quadrature de phase indépendante de la température.

Selon un autre aspect de l'invention, les signaux en quadrature de phase sont de même amplitude à une fréquence donnée et cette fréquence est dépendante d'un paramètre modifiable dynamiquement, tel que la fréquence d'un signal cadencé.

Selon une application particulière, l'invention concerne également un récepteur à réjection de la fréquence image comprenant des moyens de réception de signaux externes à une fréquence donnée, des moyens de filtrage formés d'éléments passifs, et des moyens de conversion comprenant au moins deux mélangeurs pour délivrer des signaux décalés en fréquence en quadrature de phase à une fréquence décalée ; ledit récepteur étant caractérisé en ce qu'il comprend des moyens transconducteurs ayant une transconductance proportionnelle aux éléments passifs, agencés de manière à obtenir une fonction de transfert entre les signaux décalés en fréquence, indépendante desdits éléments passifs.

L'invention va être expliquée ci-dessous en détail pour un mode d'exécution donné uniquement à titre d'exemple, cette exécution étant illustrée par les dessins annexés dans lesquels :

- la figure 1, déjà décrite, représente un générateur de signaux en quadrature de phase selon l'art antérieur ;
- la figure 2 représente un générateur de signaux en quadrature de phase selon un mode de réalisation préféré de l'invention ;
- la figure 3 représente un récepteur à réjection de la fréquence image intégrant un générateur de signaux en quadrature de phase selon l'invention ;
- la figure 3A représente le détail d'un mélangeur utilisé à la figure 3 ;
- la figure 4 représente un autre récepteur à réjection de la fréquence image ;
- la figure 4A représente le détail d'un filtre polyphasé passif de la figure 4, et
- les figures 5A et 5B représentent des exemples de réalisation de sources de courant proportionnel à la température absolue (PTAT).

La figure 2 représente un schéma de principe d'un générateur de signaux en quadrature de phase selon un mode de réalisation préféré de l'invention. On retrouve, comme dans le schéma du générateur de l'art antérieur présenté à la figure 1, un signal d'entrée Vin fourni à une borne d'entrée 2 du déphaseur 1.

La borne d'entrée 2 est reliée à des moyens de déphasage comprenant un premier circuit déphaseur 3 et un deuxième circuit déphaseur 4. Les circuits déphaseurs sont formés d'éléments passifs. Par exemple, le premier circuit déphaseur 3 comprend une résistance 7, de valeur R, connectée entre la borne d'entrée 2 et une première borne de commande 5 du générateur et un condensateur 8, de capacité C, connecté entre cette borne de commande 5 et un potentiel de référence, typiquement la masse, et le second circuit déphaseur 4 comprend un condensateur 9, de capacité C appariée à celle du condensateur 8, connecté entre la borne d'entrée 2 et une deuxième borne de commande 6 du générateur et une résistance 10, de valeur R appariée à celle de la résistance 7, connectée entre cette deuxième borne de commande 6 et la masse.

Les signaux Va et Vb, obtenus aux bornes de commande 5 et 6, sont déphasés de 90° l'un par rapport à l'autre. Comme il a été mentionné précédemment, il est possible d'obtenir un appariement quasi parfait des éléments passifs sur un même wafer. En admettant donc un appariement parfait des valeurs R des résistances 7 et 10, et des capacités C des condensateurs 8 et 9, la fonction de transfert entre les deux bornes de commande est simplifiée comme suit :

$$\frac{Va}{Vb} = \frac{1}{j\omega.R.C}$$

L'idée selon l'invention est d'obtenir une fonction de transfert indépendante de ces éléments passifs afin d'assurer une fréquence de travail quasi identique d'un wafer à l'autre. Pour cela, le générateur comprend en outre des moyens transconducteurs placés en sortie des moyens de déphasage.

Les moyens transconducteurs comprennent un premier circuit transconducteur 11 ayant une transconductance déterminée $gm_1$, et un deuxième circuit transconducteur 12 ayant une transconductance déterminée $gm_2$. Ces transconductances sont déterminées de sorte à éliminer la dépendance des éléments passifs de la fonction de transfert entre les deux bornes de sortie Out_I et Out_Q. Pour cela la transconductance $gm_1$ est proportionnelle à une valeur de capacité $C_0$ et la transconductance $gm_2$ est proportionnelle à une valeur de conductance $1/R_0$. Les valeurs $C_0$ et $R_0$ sont appariées aux valeurs des éléments passifs R et C et ce, de manière quasi parfaite, tous les éléments passifs étant sur un même wafer.

Les transconductances $gm_1$ et $gm_2$ sont respectivement sous les formes suivantes :

$$gm_1 = \alpha_1.f_{ck}.C_0$$

$$gm_2 = \alpha_2/R_0$$

où $\alpha_1$ et $\alpha_2$ représentent, chacun, un facteur de proportionnalité et $f_{ck}$ représente une fréquence de référence, par exemple celle d'un quartz.

Selon une variante de réalisation particulière, le premier circuit transconducteur 11 comprend un transistor $N_1$ dont la borne de commande $G_1$ est connectée à la première borne de commande 5 via un condensateur de couplage Cc dont la borne de courant $D_1$, qui correspond à la première borne de sortie, est connectée à une charge 13, comme par exemple une résistance, et dont la borne de courant $S_1$ est connectée à la masse. La transconductance d'un tel transistor $N_1$ est généralement donnée sous la forme suivante :

$$gm_1 = I_{N1}.g(IC_1)/(n.U_T)$$

où $I_{N1}$ est le courant appliqué à la borne de courant $D_1$ et $g(IC1)$ représente la transconductance normalisée de $N_1$.

On remarque notamment que cette transconductance dépend de la température. Afin de rendre la transconductance $gm_1$ indépendante de la température et proportionnelle à la valeur de capacité $C_0$, le courant $I_{N1}$ doit être sous la forme suivante :

$$I_{N1} = \alpha_3.U_T.f_{ck}.C_0$$

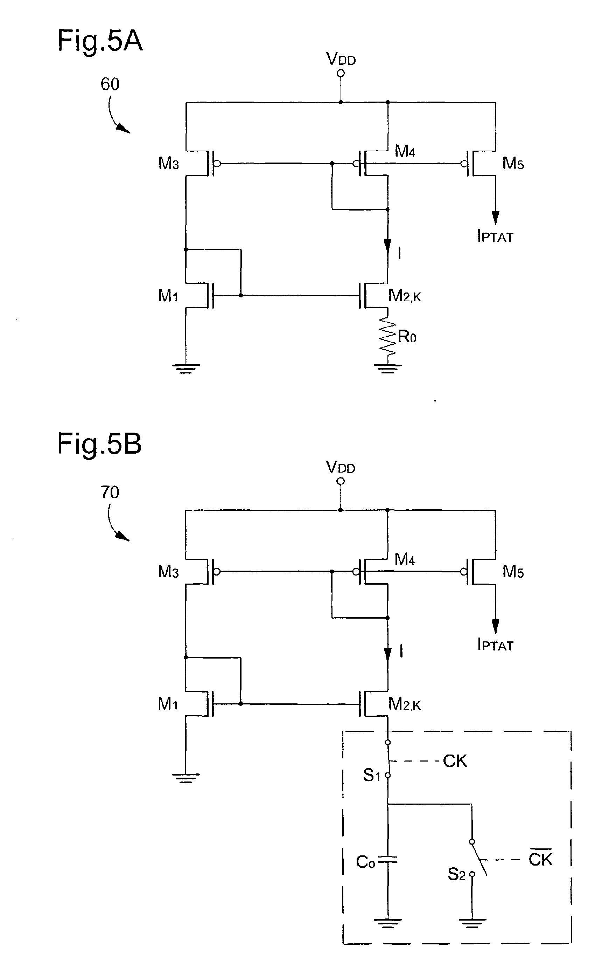

On obtient un courant sous une telle forme en utilisant une source de courant 15 proportionnel à la température absolue, appelée PTAT, fonction de la valeur de capacité $C_0$ et du signal cadencé à la fréquence $f_{ck}$. Un exemple de réalisation d'une telle source de courant est représentée à la figure 5B. Le courant $I_{N3}$, délivré par la source de courant PTAT 15, est miré au moyen d'un miroir de courant formé par les transistors $N_1$ et $N_3$. Il est à noter que le rapport entre les courants $I_{N1}$ et $I_{N3}$ peut être choisi égal à 1 ou éventuellement différent de 1 selon les besoins par le dimensionnement des transistors $N_1$ et $N_3$.

Avantageusement, le deuxième circuit transconducteur 12 comprend un transistor $N_2$, dont la borne de commande $G_2$ est connectée à la deuxième borne de commande 6 via un condensateur de couplage Cc, dont la borne de courant $D_2$ qui correspond à la deuxième borne de sortie est connectée à une charge 14 identique à la charge 13 et dont la borne de courant $S_2$ est connectée à la masse.

Afin de rendre la transconductance $gm_2$ indépendante de la température et proportionnelle à la valeur de conductance $1/R_0$, le courant $I_{N2}$ doit être sous la forme suivante :

$$I_{N2} = \frac{\alpha_4.U_T}{R_0}$$

On obtient un courant sous une telle forme en utilisant une source de courant du type PTAT fonction de la valeur de conductance $1/R_0$. Un exemple de réalisation d'une telle source de courant est représenté à la figure 5A. Le courant $I_{N4}$, délivré par la source de courant PTAT 16, est miré au moyen d'un miroir de courant formé par les transistors $N_2$ et $N_4$; le rapport entre les courants $I_{N2}$ et $I_{N4}$ étant choisi selon les besoins.

Ainsi, on obtient une fonction de transfert entre les bornes de courant $D_1$ et $D_2$ des circuits transconducteurs 11 et 12 sous la forme suivante :

$$\frac{I_{N1}}{I_{N2}} = \frac{f_{ck}}{j\omega}\frac{C_0.R_0}{C.R}\frac{\alpha_3}{\alpha_4}$$

En considérant les éléments $R_0$ et $C_0$ appariés respectivement aux éléments R et C et en polarisant les transistors $N_1$ et $N_2$ en faible inversion, ce qui fait disparaître la dépendance du facteur d'inversion $g(IC)$, on obtient une fonction de transfert indépendante de la température et de la dispersion des éléments passifs du circuit, c'est-à-dire du produit RC dans cet exemple d'application.

Il est important de remarquer que la fréquence de travail $f_0$ pour laquelle le module de la fonction de transfert vaut 1, c'est-à-dire pour laquelle les signaux de sortie Out_I et Out_Q sont de même amplitude, dépend de la fréquence $f_{ck}$ d'un signal cadencé, qui est, par exemple, un signal d'horloge délivré au moyen d'un oscillateur à quartz. Ainsi, il est possible de modifier de manière dynamique la fréquence de travail du générateur en modifiant la fréquence du signal d'horloge utilisé.

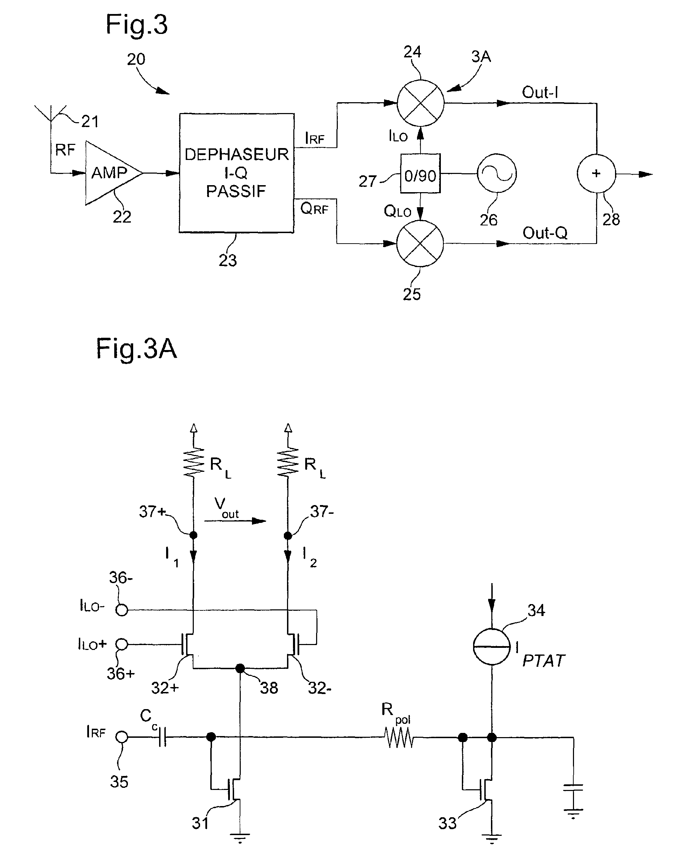

Comme il a été mentionné en introduction, ce type de générateur de signaux en quadrature de phase peut être intégré dans un récepteur à réjection de la fréquence image comme représenté aux figures 3 et 3A. Par souci de simplification, le récepteur de la figure 3 est représenté avec des signaux sous forme non différentielle. Un tel récepteur 20 comprend classiquement des moyens de réception de signaux externes, comme par exemple une antenne radiofréquence 21, pouvant être connectés à un filtre passe-bande non représenté, puis à un amplificateur à faible bruit 22. Le signal en sortie de l'amplificateur à faible bruit 22 est fourni à des moyens de filtrage, par exemple à un déphaseur I-Q 23 formé d'éléments passifs permettant d'obtenir des signaux en quadrature de phase $I_{RF}$ et $Q_{RF}$. Ces signaux $I_{RF}$ et $Q_{RF}$ sont décalés en fréquence au moyen de mélangeurs 24 et 25. Ces mélangeurs peuvent avoir une structure telle que détaillée à la figure 3A, les signaux apparaissant, dans ce cas, sous forme différentielle.

Comme il est visible sur la figure 3, chaque mélangeur comporte deux bornes de commande et une borne de sortie. Le mélangeur 24 reçoit à une borne de commande le signal $I_{RF}$ et à l'autre borne de commande un signal d'horloge en phase $I_{LO}$, et délivre, à sa borne de sortie, un signal en phase Out_I décalé en fréquence (RF-LO). Le mélangeur 25 reçoit à une borne de commande le signal $Q_{RF}$ et à l'autre borne de commande un signal d'horloge en quadrature de phase $Q_{LO}$, et délivre à sa borne de sortie un signal en quadrature de phase Out_Q également décalé en fréquence (RF-LO).

Les signaux d'horloge $I_{LO}$ et $Q_{LO}$ sont obtenus à partir d'un oscillateur local 26 délivrant un signal d'horloge à une fréquence éventuellement ajustable (LO), combiné avec un déphaseur à 90°, référencé 27. A noter qu'il est également possible d'utiliser un oscillateur local à une fréquence double (2LO) combiné avec un étage diviseur de fréquence par 2 permettant également d'obtenir les signaux $I_{LO}$ et $Q_{LO}$ désirés.

Ces signaux Out_I et Out_Q peuvent être ensuite sommés au moyen d'un sommateur 28 avant d'être traités par une unité de traitement non représentée sur la figure 3.

La figure 3A représente un exemple de réalisation du mélangeur 24 de la figure 3 dans lequel les signaux apparaissent sous forme différentielle ; le mélangeur 25 ayant une structure similaire ne sera pas représenté en détail. Comme il a été mentionné ci-avant, chacun de ces mélangeurs comprend une première borne de commande 35 recevant un signal $I_{RF}$, une deuxième borne différentielle de commande, 36- et 36+, recevant des signaux différentiels $I_{LO}$- et $I_{LO}$+ et une borne différentielle de sortie, 37- et 37+, dont le courant de sortie équivaut à la différence des courants $I_1$ et $I_2$. Le mélangeur comprend notamment un premier transistor 31 dont la borne de commande 35 reçoit le signal $I_{RF}$, les deux bornes de courant du transistor 31 étant respectivement connectées à la masse et à une des bornes de courant 38 d'une paire différentielle de deuxième et troisième transistors, 32- et 32+, dont les bornes de commande correspondent à la borne différentielle de commande, 36- et 36+, du mélangeur recevant les signaux $I_{LO}$- et $I_{LO}$ +. La borne différentielle de sortie, 37- et 37+, du mélangeur délivrant des signaux en opposition de phase Out_I-et Out_I+, est reliée, respectivement à l'autre borne de courant de la paire différentielle de transistors 32- et 32+.

L'idée selon l'invention est de pouvoir s'affranchir de la dispersion des éléments passifs lors de la suppression de la fréquence image (RF+LO). Pour cela, il est prévu de polariser le transistor 31 au moyen d'un courant proportionnel à la température absolue et à un des éléments passifs du déphaseur I-Q 23. Ce courant est obtenu, comme explicité dans le cadre de la figure 2, au moyen d'une source de courant PTAT 34.

Les courants de sortie des mélangeurs, 24 et 25, sont établis de manière à rendre la fonction de transfert entre les bornes de sorties Out_I et Out_Q indépendante des éléments passifs du déphaseur I-Q 23, comme cela a été explicité précédemment.

On notera qu'avantageusement on a utilisé, comme moyens transconducteurs, les transistors des mélangeurs déjà présents au niveau du récepteur en réglant leur transconductance de manière à s'affranchir de la dispersion des éléments passifs.

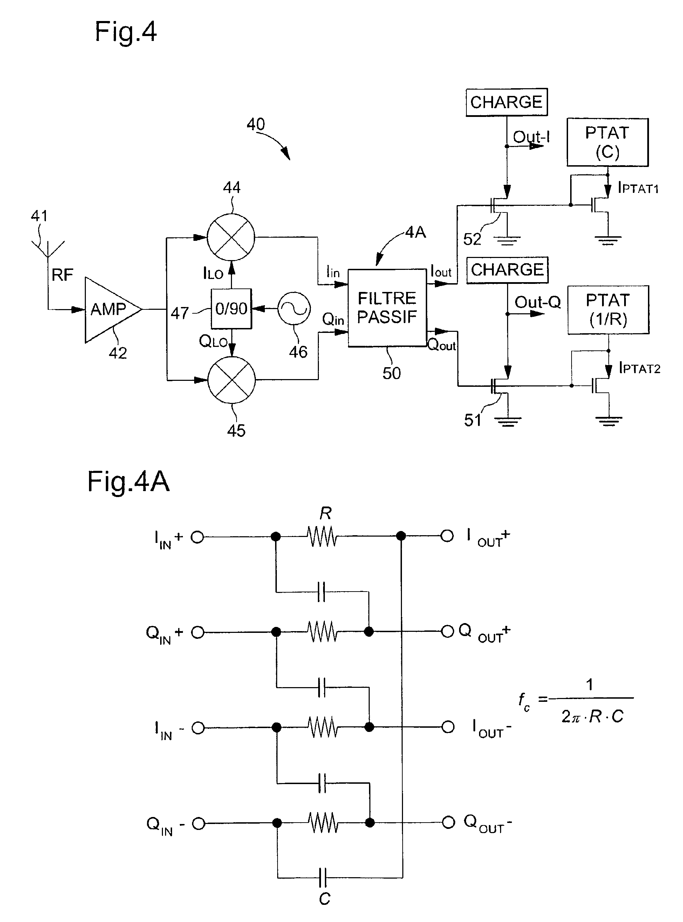

La figure 4 représente un récepteur à réjection de la fréquence image ayant une structure différente de celle du récepteur de la figure 3. Dans le même souci de simplification, le récepteur de la figure 4 est représenté avec des signaux sous forme non différentielle. Le récepteur 40 comprend un étage de réception similaire comprenant des moyens de réception de signaux externes comme, par exemple, une antenne radiofréquence 41, pouvant être connectés à un filtre passe-bande non représenté puis à un amplificateur à faible bruit 42. Le signal RF est ensuite fourni en entrée d'un étage de conversion de fréquence classique comprenant deux mélangeurs 44 et 45 similaires à celui détaillé à la figure 3A. Ces deux mélangeurs 44 et 45 sont respectivement commandés par des signaux d'horloge en quadrature de phase $I_{LO}$ et $Q_{LO}$ fournis par un oscillateur local 46 en combinaison avec un déphaseur à 90° référencé 47, et fournissent respectivement à leur sortie des signaux en quadrature de phase $I_{IN}$ et $Q_{IN}$, décalés en fréquence (RF-LO).

Les signaux $I_{IN}$ et $Q_{IN}$ sont ensuite filtrés dans un filtre passif 50 comme, par exemple, un filtre polyphasé passif dont le détail est donné à la figure 4A, les signaux apparaissant, dans ce cas, sous forme différentielle. Ce type de filtre va permettre, dans la limite de l'appariement des éléments passifs d'un récepteur à un autre, de supprimer la fréquence image (RF+LO) des signaux en quadrature $I_{OUT}$ et $Q_{OUT}$ délivrés en sortie.

La figure 4A représente un exemple de filtre polyphasé passif, dans lequel les signaux apparaissent sous forme différentielle, utilisable pour le récepteur de la figure 4.

Quatre résistances R appariées sont connectées entre les bornes, respectivement, $I_{IN}+$ et $I_{OUT}+$, $Q_{IN}+$ et $Q_{OUT}+$, $I_{IN}-$ et $I_{OUT}-$ et $Q_{IN}-$ et $Q_{OUT}-$. Quatre condensateurs C appariés sont connectés entre les bornes, respectivement, $I_{IN}+$ et $Q_{OUT}+$, $Q_{IN}+$ et $I_{OUT}-$, $I_{IN}-$ et $Q_{OUT}-$ et $Q_{IN}-$ et $I_{OUT}+$. La fréquence de coupure d'un tel filtre est donnée par la relation suivante :

$$f_c = 1 / (2\pi.R.C)$$

Afin de s'affranchir de la dispersion des éléments passifs, il est prévu des moyens transconducteurs ayant une transconductance similaire à ceux présentés dans le cadre de la figure 2.

On notera que pour les moyens transconducteurs on utilise avantageusement des éléments déjà présents comme, par exemple, des transistors fonctionnant en mode amplificateur.

Il est à noter encore que les récepteurs présentés ci-dessus (figures 3 et 4) ne tiennent pas compte du caractère différentiel éventuel des signaux pour des raisons évidentes de simplification. L'invention reste bien entendu applicable avec de tels signaux quadriphasés.

La figure 5A représente un exemple de réalisation d'une source de courant proportionnel à la température absolue (PTAT) et proportionnel à une valeur de conductance (1/$R_0$).

La source de courant PTAT 60 comprend une première paire de transistors NMOS, $M_1$ et $M_2$, une deuxième paire de transistors PMOS, $M_3$ et $M_4$, et un transistor PMOS $M_5$, formant un miroir de courant avec le transistor $M_4$.

Le transistor $M_2$ présente une largeur de canal K fois supérieure à celle du transistor $M_1$, et une longueur égale. L'une des bornes de courant de ce transistor $M_2$ est connectée à la masse via une résistance $R_0$ appariée aux résistances utilisées dans les moyens de déphasage passifs décrits précédemment. Le courant I présent à l'autre borne de courant de ce transistor $M_2$ est de la forme suivante :

$$I = \frac{U_T}{R_0} \cdot \ln K$$

Le courant I est miré dans le miroir de courant formé par les transistors $M_4$ et $M_5$, ce qui permet d'obtenir un courant de sortie $I_{PTAT}$ de la forme désirée :

$$I_{PTAT} = \frac{\alpha.U_T}{R_0}$$

en posant $\alpha = \ln K$.

La figure 5B représente un exemple de réalisation d'une source de courant proportionnel à la température absolue (PTAT) et proportionnel à une valeur de capacité (Co).

La source de courant PTAT 70 diffère de la source de courant de la figure 5A en ce que la résistance $R_0$ est remplacée un condensateur $C_0$ commuté au moyen de deux interrupteurs $S_1$ et $S_2$ commandés, respectivement, par les signaux $CK$ et $\overline{CK}$ directement liés à la fréquence $f_{ck}$ du signal d'horloge.

Le courant présent à l'autre borne de courant du transistor M2 est alors de la forme suivante :

$$I = U_T.f_{ck}.C_0.\ln K$$

Le courant I est miré dans le miroir de courant formé par les transistors M4 et M5, ce qui permet d'obtenir un courant de sortie $I_{PTAT}$ de la forme désirée :

$$I_{PTAT} = \alpha.U_T.f_{ck}.C_0$$

en posant $\alpha = \ln K$.

Un condensateur, non représenté, peut être prévu entre la borne de courant du transistor $M_2$ délivrant le courant I et la masse dans le but de court-circuiter les éléments haute-fréquence résultant des commutations à la masse.

Pour finir, il est à noter que si la description mentionne l'utilisation de transistors MOS, notamment pour la réalisation des sources de courant PTAT, il est toutefois possible d'envisager des sources au fonctionnement similaire réalisées avec des transistors bipolaires.

On remarquera également que les modes de réalisation présentés aux figures 2, 3 et 4, ne sont donnés qu'à titre d'exemple, et notamment que les sources de courant PTAT peuvent être substituées par tout moyen permettant de polariser les moyens transconducteurs du circuit de manière à obtenir une fonction de transfert indépendante des éléments passifs du circuit et de préférence de la température.

On remarquera encore que l'intégration d'un générateur de signaux en quadrature de phase selon l'invention a été donnée pour un récepteur, mais qu'il est tout à fait possible de l'intégrer dans un émetteur à réjection de la fréquence image.

Il est bien entendu que la description n'est donnée qu'à titre d'exemple et que d'autres modes de réalisation, en particulier des moyens de déphasage ou de filtrage passifs, peuvent faire l'objet de la présente invention.

## Revendications

**1.** Générateur de signaux en quadrature de phase comprenant un déphaseur (1) recevant à une borne d'entrée (2) un signal d'entrée (Vin) fourni à des moyens de déphasage (3, 4) formés d'éléments passifs, agencés pour délivrer à des première et deuxième bornes de sortie, des premier (Out I) et deuxième (Out_Q) signaux en quadrature de phase, comprenant en outre, entre les moyens de déphasage et les bornes de sortie, des moyens transconducteurs (11, 12),
caractérisé en ce que lesdits moyens transconducteurs ont une transconductance proportionnelle aux éléments passifs, agencés de manière à obtenir une fonction de transfert entre lesdits premier et deuxième signaux en quadrature de phase indépendante desdits éléments passifs.

**2.** Générateur de signaux en quadrature de phase selon la revendication 1, **caractérisé en ce que** lesdits moyens de déphasage comprennent

- un premier circuit déphaseur (3) comprenant une première résistance (7) connectée entre la borne d'entrée et une première sortie (5) des moyens de déphasage et un premier condensateur (8) connecté entre la première sortie des moyens de déphasage et un potentiel de référence,
- un deuxième circuit déphaseur (4) comprenant un deuxième condensateur (9), apparié audit premier condensateur, connecté entre la borne d'entrée et une deuxième sortie (6) des moyens de déphasage et une deuxième résistance (10), appariée à ladite première résistance, connectée entre la deuxième sortie des moyens de déphasage et ledit potentiel de référence

et **en ce que** lesdits moyens transconducteurs comprennent

- un premier circuit transconducteur (11) ayant une première transconductance ($gm_1$) déterminée proportionnelle à une capacité (C) appariée à la capacité desdits premiers et deuxième condensateurs, et
- un deuxième circuit transconducteur (12) ayant une deuxième transconductance ($gm_2$) déterminée proportionnelle à une conductance (1/R) appariée avec lesdites premières et deuxièmes résistances.

**3.** Générateur de signaux en quadrature de phase selon la revendication 2, **caractérisé en ce que** lesdites première et deuxième transconductance sont indépendantes de la température de manière à obtenir une fonction de transfert entre lesdits premier et deuxième signaux en quadrature de phase indépendante de la température.

**4.** Générateur de signaux en quadrature de phase selon la revendication 3 **caractérisé en ce que** lesdites première et deuxième transconductances sont déterminées respectivement au moyen d'une première source de courant (15) proportionnel à la température absolue et à la valeur de capacité (C), et d'une deuxième source de courant (16) proportionnel à la température absolue et à la valeur de conductance (1/R).

**5.** Générateur de signaux en quadrature de phase selon l'une quelconque des revendications précédentes, **caractérisé en ce que** lesdits signaux en quadrature de phase (Out_I, Out_Q) sont de même amplitude à une fréquence donnée ($f_0$), et **en ce que** ladite fréquence est dépendante d'un paramètre ($f_{ck}$) modifiable dynamiquement.

**6.** Générateur de signaux en quadrature de phase selon la revendication 5, **caractérisé en ce** ledit paramètre modifiable correspondant à la fréquence d'un signal cadencé.

**7.** Récepteur à réjection de la fréquence image (20 ; 40) comprenant

- des moyens de réception (21 ; 41) de signaux externes à une fréquence donnée (RF),
- des moyens de filtrage (23 ; 50) formés d' éléments passifs, et
- des moyens de conversion comprenant au moins deux mélangeurs (24, 25 ; 44, 45) pour délivrer des signaux décalés en fréquence (Out_I, Out_Q) en quadrature de phase à une fréquence (RF-LO), des moyens transconducteurs (32; 51, 52)

**caractérisé en ce que**

- lesdits moyens moyens transconducteurs (32 ; 51, 52) ont une transconductance proportionnelle aux éléments passifs, agencés de manière à obtenir une fonction de transfert entre les signaux décalés en fréquence (Out_I, Out_Q) indépendante desdits éléments passifs.

**8.** Récepteur (20) selon la revendication 8, **caractérisé en ce que** les moyens de filtrage comprennent un déphaseur I-Q passif (23) placé entre les moyens de réception (21) et les moyens de conversion (24, 25) et **en ce que** les moyens transconducteurs comprennent un premier transistor (32) du premier mélangeur (24) et un deuxième transistor du deuxième mélangeur (25).

9. Récepteur (40) selon la revendication 8, **caractérisé en ce que** les moyens de filtrage comprennent un filtre polyphasé passif (50) à au moins un étage, et **en ce que** les moyens transducteurs comprennent deux transistors en mode amplificateur.


**Claims**

1. In phase quadrature signal generator including a phase shifter (1) receiving at an input terminal (2) an input signal (Vin) supplied to phase shifting means (3,4) formed of passive elements, arranged for delivering at first and second output terminals, first (Out_I) and second (Out_Q) in phase quadrature signals, further including, between the phase shifting means and the output terminals, transconductor means (11, 12), **characterised in that** said transconductor means have a transconductance proportional to the passive elements, arranged so as to obtain a transfer function between said first and second in phase quadrature signals independent of said passive elements.

2. In phase quadrature signal generator according to claim 1, **characterised in that** said phase shifting means include

   - a first phase shifter circuit (3) including a first resistor (7) connected between the input terminal and a first output (5) of the phase shifting means and a first capacitor (8) connected between the first output of the phase shifting means and a reference potential,
   - a second phase shifter circuit (4) including a second capacitor (9), matched to said first capacitor, connected between the input terminal and a second output (6) of the phase shifting means and a second resistor (10), matched to said first resistor, connected between the second output of the phase shifting means and said reference potential

   and **in that** said transconductor means include

   - a first transconductor circuit (11) having a first determined transconductance ($gm_1$) proportional to a capacitance (C) matched to the capacitance of said first and second capacitors, and
   - a second transconductor circuit (12) having a second determined transconductance ($gm_2$) proportional to a conductance (1/R) matched with said first and second resistors.

3. In phase quadrature signal generator according to claim 2, **characterised in that** said first and second transconductance are temperature independent so as to obtain a temperature independent transfer function between said first and second in phase quadrature signals.

4. In phase quadrature signal generator according to claim 3, **characterised in that** said first and second transconductances are determined respectively by means of a first current source (15) proportional to absolute temperature and to the capacitance value (C) and a second current source (16) proportional to absolute temperature and to the conductance value (1/R).

5. In phase quadrature signal generator according to any one of the preceding claims, **characterised in that** said in phase quadrature signals (Out_I, Out_Q) have the same amplitude at a given frequency ($f_0$), and **in that** said frequency is dependent upon a dynamically modifiable parameter ($f_{ck}$).

6. In phase quadrature signal generator according to claim 5, **characterised in that** said modifiable parameter corresponds to the frequency of a clocked signal.

7. Image frequency rejection receiver (20; 40) including

   - means for receiving external signals (21; 41) at a given frequency (RF),
   - filtering means (23; 50) formed of passive elements, and
   - conversion means including at least two mixers (24, 25; 44, 45) for delivering frequency shifted in phase quadrature signals (Out_I, Out_Q) at a frequency (RF-LO),
   - transconductor means (32; 51, 52),

   **characterised in that**

   - said transconductor means (32; 51, 52) have a transconductance proportional to the passive elements, arranged so as to obtain a transfer function between the frequency shifted signals (Out_I, Out_Q) independent of said passive elements.

8. Receiver (20) according to claim 7, **characterised in that** the filtering means include a passive phase shifter I-Q (23) placed between the reception means (21) and the conversion means (24, 25) and **in that** the transconductor means include a first transistor (32) of the first mixer (24) and a second transistor of the second mixer (25).

9. Receiver (40) according to claim 8, **characterised in that** the filtering means include a passive polyphase filter (50) with at least one stage, and **in that** the transconductor means include two transistors in amplifier mode.


**Patentansprüche**

1. Generator für Signale mit 90°-Phasenverschiebung, der einen Phasenschieber (1), der an einem Eingangsanschluss (2) ein Eingangssignal (Vin) empfängt, das an Phasenschiebermittel (3, 4) abgegeben wird, die aus passiven Elementen gebildet sind, die so beschaffen sind, dass sie an einen ersten und einen zweiten Ausgangsanschluss ein erstes Signal (Out_I) bzw. ein zweites Signal (Out_Q) mit 90°-Phasenverschiebung liefern, und außerdem zwischen den Phasenschiebermitteln und den Ausgangsanschlüssen Transkonduktanzmittel (11, 12) umfasst, **dadurch gekennzeichnet, dass** die Transkonduktanzmittel eine zu den passiven Elementen proportionale Transkonduktanz besitzen und so beschaffen sind, dass eine Übertragungsfunktion zwischen dem ersten und dem zweiten Signal mit 90°-Phasenverschiebung erhalten wird, die von den passiven Elementen unabhängig ist.

2. Generator für Signale mit 90°-Phasenverschiebung nach Anspruch 1, **dadurch gekennzeichnet, dass** die Phasenschiebermittel umfassen:

    - eine erste Phasenschieberschaltung (3) mit einem ersten ohmschen Widerstand (7), der zwischen den Eingangsanschluss und einen ersten Ausgang (5) der Phasenschiebermittel geschaltet ist, und einem ersten Kondensator (8), der zwischen den ersten Ausgang der Phasenschiebermittel und ein Referenzpotential geschaltet ist,
    - eine zweite Phasenschieberschaltung (4) mit einem zweiten Kondensator (9), der mit dem ersten Kondensator gepaart ist und zwischen den Eingangsanschluss und einen zweiten Ausgang (6) der Phasenschiebermittel geschaltet ist, und einem zweiten ohmschen Widerstand (10), der mit dem ersten ohmschen Widerstand gepaart ist und zwischen den zweiten Ausgang der Phasenschiebermittel und das Referenzpotential geschaltet ist,

    und dass die Transkonduktanzmittel umfassen:

    - eine erste Transkonduktanzschaltung (11) mit einer ersten bestimmten Transkonduktanz ($gm_1$), die zu einer Kapazität (C) proportional ist, die mit der Kapazität des ersten und des zweiten Kondensators gepaart ist, und
    - eine zweite Transkonduktanzschaltung (12) mit einer zweiten bestimmten Transkonduktanz

($gm_2$), die zu einer Konduktanz (1/R) proportional ist, die mit dem ersten und dem zweiten ohmschen Widerstand gepaart ist.

3. Generator für Signale mit 90°-Phasenverschiebung nach Anspruch 2, **dadurch gekennzeichnet, dass** die erste und die zweite Transkonduktanz von der Temperatur unabhängig sind, derart, dass eine Übertragungsfunktion zwischen dem ersten und dem zweiten Signal mit 90°-Phasenverschiebung erhalten wird, die von der Temperatur unabhängig ist.

4. Generator für Signale mit 90°-Phasenverschiebung nach Anspruch 3, **dadurch gekennzeichnet, dass** die erste und die zweite Transkonduktanz anhand einer ersten Stromquelle (15), die zur absoluten Temperatur und zum Kapazitätswert (C) proportional ist, und einer zweiten Stromquelle (16), die zur absoluten Temperatur und zum Konduktanzwert (1/R) proportional ist, bestimmt sind.

5. Generator für Signale mit 90°-Phasenverschiebung nach einem der vorhergehenden Ansprüche, **dadurch gekennzeichnet, dass** die Signale mit 90°-Phasenverschiebung (Out_I, Out_Q) bei einer gegebenen Frequenz ($f_0$) die gleiche Amplitude haben und dass diese Frequenz von einem dynamisch modifizierbaren Parameter ($f_{ck}$) abhängt.

6. Generator für Signale mit 90°-Phasenverschiebung nach Anspruch 5, **dadurch gekennzeichnet, dass** der modifizierbare Parameter der Frequenz eines getakteten Signals entspricht.

7. Empfänger mit Zurückweisung der Bildfrequenz (20; 40), der umfasst:

    - Mittel (21; 41) zum Empfangen von externen Signalen mit einer gegebenen Frequenz (RF),
    - Filterungsmittel (23; 50), die aus passiven Elementen gebildet sind, und
    - Umsetzungsmittel, die wenigstens zwei Mischer (24, 25; 44, 45) enthalten, um frequenzverschobene Signale (Out_I, Out_Q) mit 90°-Phasenverschiebung mit einer Frequenz (RF-LO) abzugeben, und
    - Transkonduktanzmittel (32; 51, 52),

    **dadurch gekennzeichnet, dass**

    - die Transkonduktanzmittel (32; 51, 52) eine zu den passiven Elementen proportionale Transkonduktanz besitzen und in der Weise angeordnet sind, dass eine Übertragungsfunktion zwischen den frequenzverschobenen Signalen (Out_I, Out_Q) erhalten wird, die von den passiven Elementen unabhängig ist.

**8.** Empfänger (20) nach Anspruch 8, **dadurch gekennzeichnet, dass** die Filterungsmittel einen passiven I-Q-Phasenschieber (23) umfassen, der zwischen den Empfangsmitteln (21) und den Umsetzungsmitteln (24, 25) angeordnet ist, und dass die Transkonduktanzmittel einen ersten Transistor (32) des ersten Mischers (24) und einen zweiten Transistor des zweiten Mischers (25) umfassen.

**9.** Empfänger (40) nach Anspruch 8, **dadurch gekennzeichnet, dass** die Filterungsmittel ein passives Mehrphasenfilter (50) mit wenigstens einer Stufe umfassen und dass die Transkonduktanzmittel zwei Transistoren im Verstärkerbetrieb umfassen.

# Fig.1

# Fig.2

## Fig.3

## Fig.3A

# Fig.4

# Fig.4A

$$f_c = \frac{1}{2\pi \cdot R \cdot C}$$

## Fig.5A

## Fig.5B